# EUROPEAN PATENT APPLICATION

(11) **EP 1 617 560 A1**
(43) Date of publication of application: **18.01.2006**
(21) Application number: 04016733.0
(22) Date of filing: 15.07.2004
(51) Int. Cl.: H03H 7/42

(54) **Power amplifier circuit for output terminal of an RFIC**

(71) Applicant: Microelectronics Technology, Hsinchu (TW)
(72) Inventor: Chang, Jason L.C., Science-Based Industrial Park Hsinchu (TW)
(74) Representative: Liesegang, Eva

(57) **Abstract**

A power amplification circuit includes two identical and independent power amplifiers (22) and a balance/unbalance (24) converter. The balance/unbalance converter has a balanced terminal for inputting two signals with opposite phases and an unbalanced terminal for outputting a converted signal. The balanced terminal includes a first balanced pin and a second balanced pin to which two signals with opposite phases are applied. Furthermore, the input pins of the two power amplifiers are separately connected to the balanced output pins (211,212) of an RFIC (21) to independently amplify the power of the output signal on the balanced output terminal of the RFIC, and then the output pins of the amplifiers are connected to the first balanced pin and second balanced pin of the Balun. Therefore, the power of the output signal transmitted on the unbalanced terminal is multiplied by two.

## Description

### BACKGROUND OF THE INVENTION

### 1. Field of the Invention

The present invention relates to a power amplification circuit for an RFIC (Radio Frequency Integral Circuit) with a balanced RF output terminal, which is capable of doubling the output power compared to the conventional single-end amplification approach which is directly amplifying the output signals from a balance/unbalance (hereinafter named Balun) converter that is directly connected to the balanced output terminal.

### 2. Description of the Related Art

RF signals are generally converted by Balun transformation in today's RFIC design. Balanced transmission employs two conductors to respectively transmit two signals with phases opposite to each other. On the other hand, unbalance transmission employs only a conductor for transmitting a signal connected to a ground through which a carrier current passes to form a current loop. The balanced transmission has a differential superior characteristic, hence it can resist the interference caused by exterior noises more effectively than the unbalance transmission does.

In the practical applications of wireless communication technology, balanced transmission and unbalanced transmission are usually together applied to some cases. In conventional design approach, a balance/unbalance converter is commonly adequately utilized to convert balance signals into an unbalance signal.

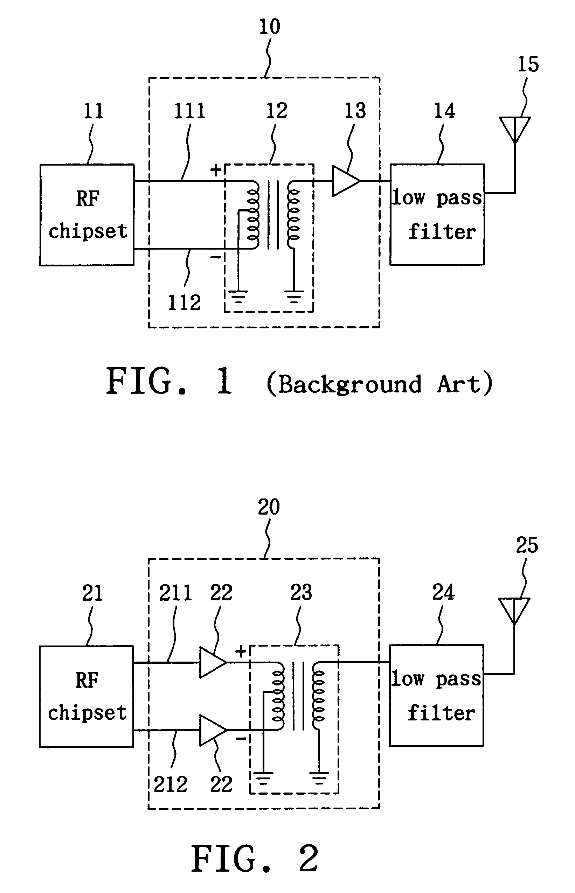

FIG. 1 is a conventional circuit diagram of an RF signal conversion and power amplification circuit 10. An RF chipset generates a first input signal and a second input signal with phases opposite to each other which are separately transmitted on the a first balanced pin and a second balanced pin. The first input signal and second input signal are converted into a single-end output signal by a balance/unbalance converter 12. Afterwards, a power amplifier 13 amplifies and sends the output signal to a low-pass filter 14 to eliminate high frequency waves therefrom. Lastly, the amplified and filtered signal is transmitted to exterior environments through an antenna 15.

An aforesaid circuit in FIG. 1 is a popular electrical configuration provided by RF device manufacturers and applied to wireless apparatuses such as communication apparatuses applied to wireless local area networks. In the layout of the circuit, if the power amplifier 13 does not have the capability of outputting higher power, the maximum output power of the antenna 15 would be limited by the power amplifier 13. Therefore, the circuit is not suitable for long-distance wireless apparatuses. Even though the conventional apparatus employs high power amplifiers 13 to overcome the problem of insufficient output power, the cost of the high power amplifier is several times higher than that of the common power amplifier. In consequence, the wireless communication apparatus does not satisfy the user as it bears a higher price.

### SUMMARY OF THE INVENTION

The primary objective of the present invention is to provide a highly efficient and low cost power amplification circuit for an RFIC with a balanced output terminal. The power amplifiers are placed right after the balanced terminal and before a Balun converter doubling the output power.

The second objective of the present invention is to provide a low-cost power amplification circuit for the balanced output terminal of an RFIC. The circuit utilizes standard amplifiers to output an RF signal with around 3dB higher power.

In order to achieve the objective, the present invention discloses a power amplification circuit for the balanced terminal of an RFIC. The power amplification circuit comprises two general and low-cost power amplifiers and a balance/unbalance converter. These two amplifiers amplify the balanced output signals from the output pins of an RFIC separately. The amplified signals are transmitted to the two balanced input pins of the Balun. Since the two amplifiers amplify the two balanced signals independently, and then the Balun converter sums up the signal power and sends the amplified signal to its unbalanced output pin. Therefore, the power of the output signal transmitted on the unbalanced output pin is multiplied by two.

### BRIEF DESCRIPTION OF THE DRAWINGS

The invention will be described according to the appended drawings in which:
FIG. 1 is a conventional circuit diagram of RF signal conversion and power amplification circuit; and
FIG. 2 is a power amplification circuit for an RFIC with a balanced output terminal in accordance with the present invention.

### PREFERRED EMBODIMENT OF THE PRESENT INVENTION

FIG. 2 is a power amplification circuit for the balance output terminal of an RFIC in accordance with the present invention. The power amplification circuit 20 can be applied to wireless communication apparatuses, such as wireless routers and wireless gateways. The RF signal generated from an RF chipset 21 and amplification circuit 20 is transmitted to exterior positions through an antenna 25.

The RF chipset 21 generates a first input signal and a second input signal with phases opposite to each other which are separately transmitted on the a first balanced pin 211 and a second balanced pin 212. The two input signals are converted into a one-pin output signal through a balance/unbalance converter 23 accompanied with a power amplification circuit. That is, the input signals acting on the balance terminal are transformed into the output signal acting on the unbalanced terminal. Two power amplifiers 22 are separately connected to the first balanced pin 211 and second balanced pin 212 in a series manner to independently amplify the power of the signal transmitted on the individual pin. Since the power amplifiers 22 have the same specification, the output power of the present invention is about twice of the prior art. Afterwards, high frequency waves are eliminated from the output signal on the unbalanced terminal through a low-pass filter 24. At last, an RF signal is transmitted to exterior circumstances through an antenna 25. A common power transistor can act as the power amplifier 22, whereas the amplifier fabricated by monolithic microwave integrated circuit (MMIC) technology is preferable.

Theoretically, if the insertion loss of the balance/unbalance converter 23 is very low, the circuit in FIG. 2 raises its output power by about 3 dB. The circuit employs devices whose specifications are the same as the specifications of the devices used in the prior art. Therefore, we can gain much profit from being skillful at employing the standard mass-production devices with low costs. On the other hand, devices or materials with various models are unnecessary, hence the manufacturing inventories can be effectively reduced. In conclusion, the present invention indeed provides a low-cost and inventive power amplification circuit, and it is suitable for any circuit that includes a chipset outputting balance signals and needs to be amplified its output power. However, the scope of the present invention is not limited to apply to wireless apparatuses for a WLAN or WiFi use.

The above-described embodiments of the present invention are intended to be illustrative only. Numerous alternative embodiments may be devised by persons skilled in the art without departing from the scope of the following claims.

## Claims

1. A power amplification circuit for the output terminal of an RFIC, comprising:
a balance/unbalance converter including a balance terminal and an unbalance terminal, wherein the balanced terminal has a first balanced pin and a second balance pin; and
at least two power amplifiers separately connected to the first balanced pin and the second balanced pin in a series manner.

2. The power amplification circuit for the output terminal of an RFIC of Claim 1, wherein the power amplifier is an MMIC.

3. The power amplification circuit for the output terminal of an RFIC of Claim 1, wherein the power amplifier is a power transistor.

4. The power amplification circuit for the output terminal of an RFIC of one of the preceding claims, wherein two identical and independent amplifiers are connected to the balanced output terminal of the RFIC.

5. The power amplification circuit for the output terminal of an RFIC of one of the preceding claims, wherein the balanced terminal receives a pair of RF signals with opposite phases generated by the RFIC.
